# EUROPEAN PATENT APPLICATION

(11) **EP 1 309 004 A1**
(43) Date of publication of application: **07.05.2003**
(21) Application number: 02702745.7
(22) Date of filing: 05.03.2002
(51) Int. Cl.: H01L 25/04

(54) **SEMICONDUCTOR DEVICE**

(30) Priority: 09.03.2001 JP 2001067456
(71) Applicant: Sony Corporation, Tokyo 141-0001 (JP)
(72) Inventor: MATSUNAMI, Keisuke, c/o SONY CORPORATION, Tokyo 141-0001 (JP)
(74) Representative: Müller - Hoffmann & Partner
(86) International application number: JP0202039
(87) International publication number: WO02073693

(57) **Abstract**

The present invention provides a semiconductor device (1) which has a motherboard (20) as a base substrate, and an interposer (2) as an intermediate substrate which is arranged on the motherboard (20) via bumps (19). The interposer (2) has a semiconductor chip (15) arranged on a surface thereof facing the motherboard (20).

## Description

### Technical Field

The present invention relates to a semiconductor device having a package which enables high-density arrangement.

### Background Art

Conventionally, there are widely used portable small-sized electronic apparatuses called mobile-type electronics. This type of electronic apparatus has a small main body, and space for arranging electronic parts or components inside the apparatus is restricted. This type of electronic apparatus is required to be reduced in size as well as improved in operational function. So as to realize high function of the apparatus itself, many functional components such as semiconductor chips and passive elements are inevitably required. Thus, such functional components have to be arranged on a motherboard, which is placed in the restricted arrangement space of the main body of the apparatus, in high-density arrangement or in a manner of arranging electronic components with high density.

There are proposed semiconductor devices of package configuration such as the Chip Size Package (CSP) or the Ball Grid Array (BGA) in order to arrange various electronic components on a motherboard in high-density arrangement.

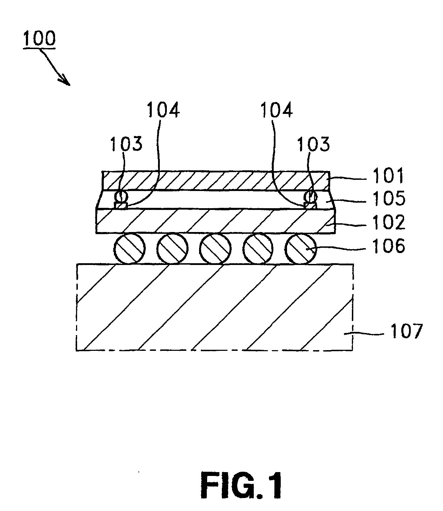

FIG.1 shows one specific configuration of such semiconductor devices. A semiconductor device 100 shown in FIG.1 is of the chip size package (CSP) configuration, in which a semiconductor chip 101 and an intermediate substrate (interposer) 102 is connected in the flip chip bonding to reduce the dimension along the height direction so as to make the package size of the semiconductor device 100 as equal as possible to that of the semiconductor chip 101.

The semiconductor device 100 shown in FIG.1, which undergoes the flip chip bonding, employs so-called face down bonding, that is, bumps 103 being protruding electrodes are formed on the surface electrode of the semiconductor chip 101, and then the bumps 103 and electrodes 104 of the interposer 102 are put together after upsetting the semiconductor chip 101. Also, synthetic resin 105 is sealed between the semiconductor chip 101 and the interposer 102. The semiconductor device 100, being of the package configuration shown in FIG.1, can be arranged on a motherboard 107 in high-density arrangement.

Recently, the requirement of high-density arrangement for arranging electronic components including semiconductor devices on a motherboard is further increasing, and therefore semiconductor devices are required to be reduced in size further, and also further high-density arrangement is required.

Generally, a semiconductor device has a semiconductor chip and an interposer connected in the flip chip bonding to be integrated, and thus integrated component, independent of chips such as passive elements, is arranged on a motherboard as one functional component.

There is also a semiconductor device which has a semiconductor chip and passive elements integrated on an interposer, whereas the size of the semiconductor device itself is not equal to the package size of the CSP, etc. The package size, especially along the height direction, is caused to be large, which makes it difficult to house the semiconductor device in the restricted arrangement space of the main body of the above-described small-sized electronic apparatus.

On the other hand, a semiconductor device may be configured to be a specific module to realize high-density arrangement. However, the cost of components to be built in the module is undesirably caused to be increased, which also increases the cost of the semiconductor device.

### Disclosure of the Invention

Accordingly, the present invention has an object to provide a new semiconductor device which can overcome the above-mentioned drawbacks of the prior art.

The present invention has another object to provide a semiconductor device which can be reduced in size further and enable further high-density arrangement, without increasing the cost.

The above object can be attained by providing a semiconductor device, including:
a base substrate; and
an intermediate substrate which is arranged on the base substrate via bumps;
wherein the intermediate substrate has a chip arranged on a surface thereof facing the base substrate.

According to the semiconductor device of the present invention, when effectively utilizing a space formed between the intermediate substrate and the base substrate with the bumps therebetween, a chip can be arranged on the bottom surface of the intermediate substrate by suppressing the dimension along the height direction of the semiconductor device. Thus, the semiconductor device can be reduced in size further and enable further high-density arrangement.

These objects and other objects, features and advantages of the present invention will become more apparent from the following detailed description of the preferred embodiments of the present invention.

### Brief Description of the Drawings

FIG.1 shows a cross-sectional view of the conventional semiconductor device.
FIG.2 shows a cross-sectional view of the semiconductor device according to the present invention.
FIG.3 shows a top view of the semiconductor device shown in FIG.2 viewed from the direction facing a motherboard.
FIG.4 shows a cross-sectional view of another example of the semiconductor device according to the present invention.
FIG.5 shows a top view of the semiconductor device shown in FIG.4 viewed from the direction facing a motherboard.

### Best Mode for Carrying Out the Invention

The present invention will further be described below concerning the best modes with reference to the accompanying drawings.

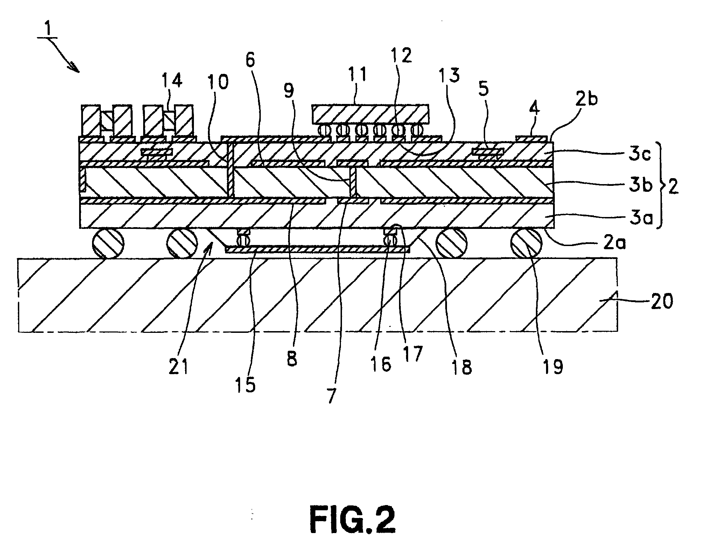

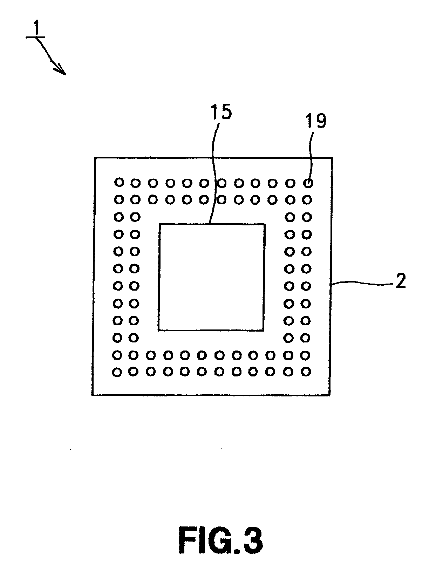

A semiconductor device 1 according to the present invention, which is of the package configuration enabling high-density arrangement on a motherboard 20, has an interposer 2 which itself works as one functional component, as shown in FIG.2 and FIG.3.

Specifically, the interposer 2 consists of organic substrates 3a, 3b, 3c made of dielectric material put together via prepreg, not shown. The interposer 2 is of four-layer built up structure, that is, each of the bottom surface 2a of the organic substrate 3a facing the motherboard 20, the bottom and top surfaces of the organic substrate 3b, the top surface 2b of the organic substrate 3c not facing the motherboard 20 has a metal wiring layer.

The metal wiring layer has functional elements such as a resonator (filter) 4, a capacitor 5 and an inductor 6, and a wiring pattern 7 and a ground pattern 8 for connecting these functional elements, which functional elements and patterns are formed into layer configuration. Respective functional elements are electrically connected by the wiring pattern 7 and the ground pattern 8 via a via hole 9and a through hole 10 which penetrate the organic substrates 3a, 3b, 3c.

The interposer 2 has a semiconductor chip 11 arranged on the top surface 2b thereof in the flip chip bonding. The semiconductor device 11 which undergoes the flip chip bonding employs so-called face down bonding, in which bumps being protruding electrodes are formed on the surface electrode of a semiconductor chip, and then the bumps and electrodes of an interposer are put together after upsetting the semiconductor chip. In this embodiment, the semiconductor chip 11 is connected to the interposer 2 under the face down bonding, that is, bumps 12 are formed on the semiconductor chip 11, and these bumps 12 and electrodes 13 of the interposer 2 are put together to be heated and melted. By employing the flip chip bonding, space for wiring becomes unnecessary as compared with the wire bonding, and the dimension along the height direction can be significantly reduced.

The interposer 2 has chips 14 such as passive elements arranged on the top surface 2b thereof, as shown in FIG.2.

On the other hand, the interposer 2 has a semiconductor chip 15 arranged on the bottom surface 2a thereof in the flip chip bonding.

Specifically, the semiconductor chip 15 is ground to be approximately 50 ∼ 100 µm in thickness, and the semiconductor chip 15 is connected to the interposer 2 under the face down bonding, that is, bumps 16 are formed on the semiconductor chip 15, and these bumps 16 and electrodes 17 of the interposer 2 are put together to be heated and melted. Thus, the dimension along the height direction can be significantly reduced. Also, synthetic resin 18 is sealed between the semiconductor chip 15 and the interposer 2.

The interposer 2 has bumps 19 made up of a plurality of pieces of solder arranged on the bottom surface 2a thereof such that the bumps 19 surrounds the semiconductor chip 15, as shown in FIG.3. The bumps 19 are used to arrange the semiconductor device 1 onto the motherboard 20, and are formed such that the thickness thereof is larger than that of the semiconductor chip 15. The thickness of the bumps 19 is approximately 200 ∼ 250 µm. Thus, when the semiconductor device 1 is arranged onto the motherboard 20, the semiconductor chip 15 arranged on the bottom surface 2a of the interposer 2, which faces the motherboard 20, is prevented from coming into contact with the motherboard 20. That is, since the thickness of the bumps 19 is caused to be larger than that of the semiconductor chip 15, there is provided a space 21 large enough to arrange the semiconductor chip 15 between the interposer 2 and the motherboard 20.

Thus configured semiconductor device 1 is arranged onto the motherboard 20 as one functional component with the bumps 19 sandwiched therebetween. The thickness of the semiconductor device 1 arranged on the motherboard 20 is approximately 1.2 mm. With the semiconductor device 1, as described above, the semiconductor chip 15 can be arranged on the bottom surface 2a of the interposer 2 on which the bumps 19 are formed. That is, when effectively utilizing the space 21 formed between the interposer 2 and the motherboard 20 with the bumps 19 therebetween, the semiconductor chip 15 can be arranged on the bottom surface 2a of the interposer 2 by suppressing the dimension along the height direction of the semiconductor device 1.

Thus configured semiconductor device 1 can be reduced in size further and enable further high-density arrangement without increasing the cost. Thus, the semiconductor device 1 can be arranged in a restricted arrangement space of a small-sized electronic apparatus.

With the semiconductor device 1, besides passive elements being the metal wiring layer arranged on the inner layer and outer layer of the interposer 2, passive elements being chips can be arranged on the bottom surface 2a and the top surface 2b of the interposer 2. Thus, burden on the metal wiring layer arranged on the interposer 2 can be significantly reduced.

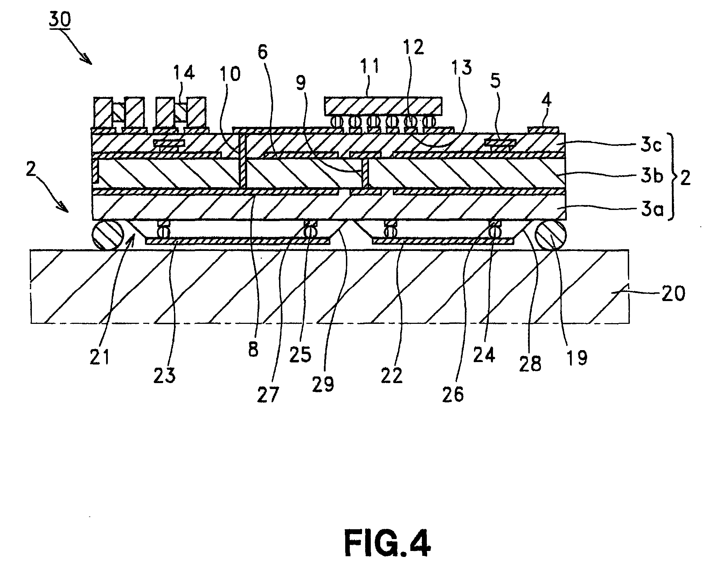

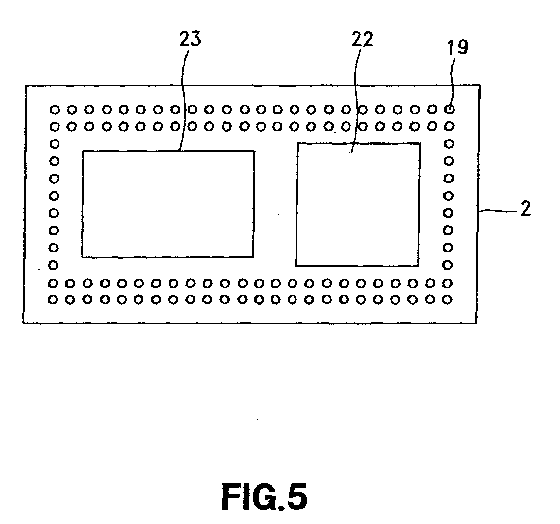

The present invention is applicable also to the semiconductor device 30 shown in FIG.4 and FIG.5. FIG.4 shows a cross-sectional view of the semiconductor device 30, while the FIG.5 shows a top view of the semiconductor device 30 viewed from the direction facing the motherboard 20.

In the following explanation, parts or components similar to those of the semiconductor device 1 are indicated with the same reference numerals, and detailed description thereof will be omitted.

In the semiconductor device 30, the interposer 2 has semiconductor chips 22, 23 arranged on the bottom surface 2a thereof in the flip chip bonding. Specifically, the semiconductor chips 22, 23 are ground to be approximately 50 ∼ 100 µm in thickness, and the semiconductor chips 22, 23 are connected to the interposer 2 under the face down bonding, that is, bumps 24, 25 are formed on the semiconductor chips 22, 23, and these bumps 24, 25 and electrodes 26, 27 of the interposer 2 are put together to be heated and melted. Thus, the dimension along the height direction can be significantly reduced. Also, synthetic resin 28, 29 are sealed between the semiconductor chips 22, 23 and the interposer 2.

The interposer 2 has bumps 19 made up of a plurality of pieces of solder arranged on the bottom surface 2a thereof such that the bumps 19 surrounds the semiconductor chips 22, 23, as shown in FIG.5. The bumps 19 are used to arrange the semiconductor device 30 onto the motherboard 20, and are formed such that the thickness thereof is larger than that of the semiconductor chips 22, 23. The thickness of the bumps 19 is approximately 200 ∼ 250 µm. Thus, when the semiconductor device 30 is arranged onto the motherboard 20, the semiconductor chips 22, 23 arranged on the bottom surface 2a of the interposer 2, which faces the motherboard 20, are prevented from coming into contact with the motherboard 20. That is, since the thickness of the bumps 19 is caused to be larger than that of the semiconductor chips 22, 23, there is provided a space 21 large enough to arrange the semiconductor chips 22, 23 between the interposer 2 and the motherboard 20.

Thus configured semiconductor device 30 is arranged onto the motherboard 20 as one functional component with the bumps 19 sandwiched therebetween. The thickness of the semiconductor device 30 arranged on the motherboard 20 is approximately 1.2 mm.

With the semiconductor device 30, as described above, the semiconductor chips 22, 23 can be arranged on the bottom surface 2a of the interposer 2 on which the bumps 19 are formed. That is, when effectively utilizing the space 21 formed between the interposer 2 and the motherboard 20 with the bumps 19 therebetween, the semiconductor chips 22, 23 can be arranged on the bottom surface 2a of the interposer 2 by suppressing the dimension along the height direction of the semiconductor device 30.

Similar to the semiconductor device 1, thus configured semiconductor device 30 can be reduced in size further and enable further high-density arrangement without increasing the cost. Thus, the semiconductor device 30 can be arranged in a restricted arrangement space of a small-sized electronic apparatus.

With the semiconductor device 30, besides passive elements being the metal wiring layer arranged on the inner layer and outer layer of the interposer 2, passive elements being chips can be arranged on the bottom surface 2a and the top surface 2b of the interposer 2. Thus, burden on the metal wiring layer arranged on the interposer 2 can be significantly reduced.

Concerning the semiconductor device 1 and the semiconductor device 30 employing the present invention, the interposer 2 is not restricted to the above-described configuration in which the organic substrates 3a, 3b, 3c are put together, and may be a silicon substrate. Furthermore, chips such as passive elements may be arranged on the bottom surface 2a of the interposer 2, which faces the motherboard 20, besides or instead of the semiconductor chips 15, 22, and 23.

### Industrial Applicability

As in the above, according to the semiconductor device of the present invention, the intermediate substrate, which is arranged on the base substrate via bumps, has a chip arranged on a surface thereof facing the base substrate. Thus, the semiconductor device can be reduced in size further and enable further high-density arrangement, without increasing the cost. So, it becomes possible to house the semiconductor device in the restricted arrangement space of the main body of the small-sized electronic apparatus.

## Claims

1. A semiconductor device, comprising:
a base substrate; and
an intermediate substrate which is arranged on the base substrate via bumps;
wherein the intermediate substrate has a chip arranged on a surface thereof facing the base substrate.

2. The semiconductor device as set forth in Claim 1, wherein the thickness of the bumps is caused to be larger than that of the chip.

3. The semiconductor device as set forth in Claim 1, wherein the other surface of the intermediate substrate not facing the base has a chip arranged thereon.
